Europäisches Patentamt

European Patent Office

Office européen des brevets

(19)

(11) **EP 1 659 695 A1**

(12) **EUROPEAN PATENT APPLICATION**

(43) Date of publication:
**24.05.2006 Bulletin 2006/21**

(51) Int Cl.:
*H03M 13/29* (2006.01)

(21) Application number: **04027770.9**

(22) Date of filing: **23.11.2004**

(84) Designated Contracting States:
**AT BE BG CH CY CZ DE DK EE ES FI FR GB GR HU IE IS IT LI LU MC NL PL PT RO SE SI SK TR**
Designated Extension States:
**AL HR LT LV MK YU**

(71) Applicant: **SIEMENS AKTIENGESELLSCHAFT 80333 München (DE)**

(72) Inventors:
• **Hagenauer, Joachim, Prof.**
**82229 Seefeld (DE)**
• **Jenkac, Hrvoje**
**81373 München (DE)**
• **Xu, Wen, Dr.**
**82008 Unterhaching (DE)**

(54) **Turbo-fountain code and its application for reliable wireless broadcast**

(57) We introduce a novel type of rateless codes based on the turbo principle: the turbo-fountain. The turbo-fountain is able to consider soft information from the channel in the decoding process. Two realizations for the turbo-fountain are introduced. It is shown that the turbo-fountain provides significant performance gains, due to exploitation of soft information, and approaches capacity.

EP 1 659 695 A1

**Description**

I. INTRODUCTION

Reliable wireless broadcast has gained significant interest recently with the standardization and introduction of Multimedia Broadcast and Multicast Services (MBMS) into wireless cellular networks. Whereas many types of multimedia data tolerate residual errors to some extend, like video streaming or music distribution, in general, file download must be performed error-free, e.g. the distribution of executable programs. Broadcasting to wireless receivers in a cellular environment causes different receiving conditions for several receivers. Furthermore, link adaptation cannot be utilized in the broadcast mode.

Therefore, approaches based on Automatic Repeat request (ARQ) have been proposed and protocols for broadcast ARQ elaborated. However, all retransmission strategies require a feedback channel from the receivers to the transmitter. This is not feasible for a multitude of receiving entities, as it is the case within a football stadium where replays are distributed to a vast number of cell phones. Furthermore, the system throughput applying ARQ is degenerating with a growing number of receiving entities. This phenomenon is also known as feedback implosion.

Alternatively, Forward Error Correction (FEC) with a fixed code rate can be applied. However, this results in unnecessary reception overhead for receivers with good channel conditions, and residual errors for receivers with bad or moderate channel state. Moreover, both solutions do not allow asynchronous access of receivers to the data.

In [1] or [2] FEC for reliable broadcast was investigated and, furthermore, in [3], it was elaborated that a channel code with potentially limitless redundancy *(rateless)* is able to solve the reliable broadcast problem. Such a code is denoted as *fountain code.* A protocol was presented in order to solve the reliable multicast problem over erasure channels by applying fountain codes. Practical approximations of a *digital fountain* have been obtained by the introduction of LT-Codes [4] and Raptor codes [5], optimized for transmission over the erasure channel.

Fountain codes were initially optimized and investigated on the erasure channel, since the loss behavior of the Internet can be modeled by the erasure channel, because packets do not arrive at the receiver at all, because of router congestion. However, in wireless broadcast other channel models apply, like the Gaussian channel or the fading channel. These types of channel models provide soft-information about each received bit. In [6] and [7] first investigations of LT-Codes and Raptor codes over the AWGN channel have been performed. In addition, recently in [8] the author encourages the research community to look for novel types of digital fountain codes and digital fountain approximations.

In this invention, we present an alternative method to produce a limitless stream of redundancy. We introduce a digital fountain by applying turbo codes: the *turbo-fountain.* Moreover, we investigate the performance of the turbo-fountain on the AWGN and on fading channels, and provide a powerful decoding technique which exploits soft-information of the channel. We show how the *turbo-fountain* can be applied to reliable broadcast in a wireless environment.

In Section II we introduce the framework and formalize the problem. Subsequently, we present several realizations of the turbo-fountain. In Section IV we introduce our simulation setup and provide simulation results of the performance when applying the turbo-fountain. Finally, in Section V we summarize the major results.

II. PROBLEM FORMALIZATION

*A. Framework*

We consider a transmission system with a single transmitter and multiple receivers. The goal of this system is to broadcast a message reliably to all receivers, i.e. without residual errors or missing data within the message. We assume that no feedback channel is available to request retransmissions for lost data. However, every single receiver should be able to receive the message error-free, independent of its channel quality.

In [3] the idea of a *digital fountain* was introduced. We assume that the reader is familiar with the benefits of rateless coding, the fountain idea, and possible applications. In the following, we only recall some basic properties. Recently, a survey on digital fountains and their applications has been presented in [8].

Fountain codes allow multiple receivers to recover form different loss patterns. Moreover, an asynchronous start of data reception among the receivers is possible, i.e. every receiver can decide when to start to receive data. Entailed with the application of fountain codes, there are many further nice properties, like the reception from multiple transmitters or the arbitrary number of possible receivers. Furthermore, fountain codes allow reception pauses, for example initiated by cell reselection in the case of a wireless cellular system. A small drawback of the fountain concept is the limitation on download and play services, i.e. this concept is not applicable for real-time service like video streaming, maintaining the same marvelous properties. Recently, there are many publications in many research areas adopting the fountain idea where rateless codes are applied to solve various problems.

*B. Setup and Notations*

Consider the information message $u=(u_1,\cdots,u_k)$ of length $k$ symbols, where all symbols $u_i$ are of the same cardinality. For practical purposes $u_i$ can represent a single bit or a tuple of bits. This information message $u$ is encoded with a fountain code $F,$ which is assumed to produce an infinite sequence of code symbols $c=(c_1,c_2,c_3\cdots)$ from the finite information sequence $u$, where $c=F(u)$. The code symbols $c_i$ are assumed to be broadcasted over the broadcast channel in a successive manner. At the receiver of interest, the symbol sequence $y=(y_1,y_2,y_3...)$ is received. Note that $c_i$ and $y_i$ need not to be from equal alphabets, this depends on the channel only. Now, let us define the receiver pattern $r = (r_1, r_2,...,r_i,...)$, containing random variables $r_i$, where $r_i \in \{0,1\}$. $r_i=1$ indicates that the receiver listens to the channel, whereas $r_i=0$ is equivalent to the fact that the receiver does not listen to the channel, i.e. it does not receive the symbol $i$. In fact, this corresponds to the well known puncturing and $r$ represents a puncturing pattern. Let us define $\hat{c}=(\hat{c}_1,\hat{c}_2,\hat{c}_3,\cdots)$, with

$$\hat{c}_i = \begin{cases} y_i & r_i = 1 \\ p & r_i = 0 \end{cases}$$

and $\hat{c}_i=p$ indicating that a certain symbol $c_i$ was punctured as a consequence of not listening to the channel. Moreover, let us define

$$\left|\hat{c}_i\right| = \left\|i \mid \hat{c}_i \neq p\right\| \qquad (1)$$

as the number of overall available, unpunctured symbols at the receiver. Finally, we define the decoding process as $\hat{u}=F^{-1}(\hat{c})$, with denoting the decoding decision on the information sequence.

*C. Erasure Fountain Codes (EFC)*

Traditionally the fountain idea was evolved for the erasure channel [3]. Consider the memoryless erasure channel with its transition probabilities

$$\begin{aligned} \Pr\{y_i = \varepsilon\} &= p_\varepsilon \\ \Pr\{y_i = c_i\} &= 1 - p_\varepsilon \end{aligned}$$

$$(2)$$

with $\varepsilon$ denoting an erasure marker and $p_\varepsilon$ the erasure probability. Hence, $\hat{c}_i \in \{c_i,\varepsilon,p\}$ contains a code symbols $c_i$, an erasure marker $\varepsilon$ or a puncturing indicator $p$, respectively. We define

$$\kappa = \left\|\{i \mid \hat{c}_i \neq p \wedge \hat{c}_i \neq \varepsilon\}\right\| \qquad (3)$$

as the number of overall available un-punctured and un-erased symbols at the receiver. Now, the Ideal Erasure Fountain Code (IEFC) $F_I$ is defined by the following property

$$F_I : \left\{F_I^{-1}(\hat{c}) \equiv u \; \forall \hat{c} \mid \kappa \geq k\right\} \qquad (4)$$

i.e., the reception of at least k arbitrary code symbols is sufficient to guarantee decoding success. Note, this corresponds to the well know Maximum Distance Separable (MDS) property. Unfortunately, practical codes do not achieve the MDS property. Usually a slightly increased number $\kappa = k'$ symbols ($k' > k$) is required to be received. The inefficiency of practical EFCs is expressed by $e$, with $k' = (1+e)k$. Currently, the research community is working towards $e \to 0$ with reasonable complexity [4], [5], [9]. A nice property for the code design of fountain codes over erasure channels is the fact that code optimization can be performed without knowledge about the channel loss rate.

*D. Problem Generalization to Arbitrary Channels*

In wireless communications, transmitted symbols are not lost like in Internet communications. In this work we extend the fountain idea to more appropriate channel models, concerning wireless communications, like the Gaussian channel or fading channels. These types of channels are commonly characterized by their probability density functions $p_{y_i}(y_i|c_i)$ and provide soft-information [10] about the received symbols. We generalize (4) and define the capacity achieving, ideal fountain code $F_s$ to fulfill the property

$$F_S : \left\{ F_I^{-1}(\hat{c}) \equiv u \; \forall \hat{c} \mid |\hat{c}| \geq \left\lceil \frac{k}{C} \right\rceil \right\} \qquad (5)$$

where C is the Shannon's channel capacity which can be calculated from $p_{y_i}(y_i|c_i)$. This means, the reception of at least $\left\lceil \dfrac{k}{C} \right\rceil$ arbitrary symbols is sufficient to guarantee decoding success. It can be easily shown that (4) is obtained from (5) by inserting the channel capacity of the erasure channel. However, the formulations in (4) and (5) do not give any practical instructions how to find such codes, but just the desired properties.

III. TURBO-FOUNTAIN

In Section II-D the properties of a capacity achieving fountain codes have been formalized. Though no proof is given, intuitively, it seems to be a challenging and complex task to find such codes. In this section we apply the capacity approaching turbo codes [10], [11], [12] to approximate an ideal fountain. We describe two different realizations which have in common to produce an infinite sequence of code symbols from a finite information sequence, according to the fountain idea. Furthermore, we introduce corresponding decoder structures based on soft-in/soft-out component decoders, in order to exploit the available soft information from the channel efficiently. In the following, we restrict to $u_i \in \{0,1\}$ and $c_j \in \{0,1\}$.

*A. Parallel Turbo Codes*

Fig. 1. Encoder structure for turbo-fountain TF-A based on

parallel concatenated convolutional codes and infinite number of

random interleavers at the output.

Fig. 1 shows the block diagram of the turbo-fountain encoder, based on two parallel concatenated convolutional codes. In the following, we denote this structure as *TF-A*. The information bits $u$ are successively applied to the encoder input, and directly passed to the first component encoder. Additionally, an interleaved version of $u$ is passed to the second component encoder in the same manner, where $\pi$ is denoting a random interleaver. Both component encoders are rate $R_c$=1/2 recursive systematic convolutional encoders, with two outputs. The first output provides systematic bits and the second output parity bits. In order to avoid duplicate transmission of systematic bits, the systematic bits of the second component encoder are punctured away. Note, this is not the case for the corresponding termination bits. After a parallel-serial conversion, all output bits from both encoders, which are the systematic bits, parity bits from both encoders and termination bits from all outputs are applied to a potentially limitless number of random interleavers ($\pi_1$, $\pi_2$,...), with $\pi_i \neq \pi_j \; \forall i \neq j$. In practice, the number of required interleavers depends on the number of required redundancy. Finally, the interleaved bits from each interleaver branch are mapped successively onto the output $c$.

Fig. 2. Soft-in/soft-out decoder for turbo-fountain TF-A.

Fig. 2 shows the corresponding decoder structure. The L-value [10] $L(\hat{c})$ of the received bits are distributed to different branches inversely to the procedure at the encoder output. In general, we assume that the transmitter and the receivers utilize synchronized pseudo random generators, which can easily be realized in wireless systems, since the data is transmitted block-wise and, hence, sequence or frame numbers are available to initialize the pseudo random generator at the receivers. In general, the synchronization issue applies to any type of fountain codes and is not a special problem of the turbo-fountain. After distributing the L-values to the different branches, appropriate de-interleaving $\pi_i^{-1}$ in each branch $i$ is performed. Then, the deinterleaved L-values from all branches are combined (bit-wise summation) and passed to a state-of-the art turbo decoder [11] with two soft-in/soft-out component APP decoders. Within each iteration extrinsic information is exchanged between the component decoders, which serves as a-priori information for the other decoder. The L-values on the decoding decision $L(\hat{u})$ are obtained at the decoder output, where $|L(\hat{u})|$ is the hard decision on each bit.

*B. Multiple Turbo Codes*

With TF-A, code bit outputs at time index $i$ are output again later at time index $i'>i$. Therefore, we looked for an encoder structure which avoids repetition of code bits, in order to avoid collecting identical code bits several times at the receiver. Now, we present a solution based on multiple turbo codes, as introduced and proposed for deep-space communication in [13] or in [14], and denote the structure as *TF-B* in the following. Multiple turbo codes are turbo codes with more than 2 parallel concatenated component codes. We extend the idea of multiple concatenated encoders and allow a potentially limitless number of parallel encoders.

Fig. 3. Encoder structure for turbo-fountain TF-B based on infinite parallel concatenation of recursive systematic convolutional codes.

Fig. 3 shows the block diagram of the encoder. The $k$ information bits $u$ are applied to the first component encoder $RSC_0$ without interleaving, whereas all other encoders $RSC_i$, with i > 0; obtain an interleaved version $\pi_i(u)$ of the information bits. Again $(\pi_1, \pi_2, ...)$ are random interleavers, with $\pi_i \neq \pi_j$ $\forall i \neq j$ and again, the component encoders are rate $R_c$ = 1/2 recursive systematic convolutional encoders. All output bits from $RSC_0$ (systematic, parity and termination bits) are passed to a random interleaver $\pi_0'$. From all other component encoders the systematic bits are punctured away. Again, this is not the case with the termination bits. After random interleaving with $\pi_i'$, the bits from all branches $i$ are mapped consecutively onto the output $c$.

Fig. 4. Soft-in/soft-out decoder for turbo-fountain TF-B.

Fig. 4 shows a possible decoder structure. The L-values $L(\hat{c})$ of the received bits are distributed to the different branches, inversely to the procedure at the encoder output. The first branch contains the systematic bits. In order to pass systematic information to all component decoders, the systematic bits from the first branch are interleaved appropriately with the interleavers $\pi_i$. As mentioned in the previous section, we assume that the corresponding random interleavers are obtained by synchronized pseudo random generators. The parity bits designated for the different component decoders, which are received successively after the systematic bits, are passed after de-interleaving with $\pi_i^{-1}$ on the corresponding branches to the dedicated component decoders. In [13] several iterative decoding strategies for multiple turbo codes were presented. We apply parallel decoding, where all component decoders operate at the same time in parallel. Each component decoder DEC$_i$ is feed with a-priori information $L_{a,i}$ which is obtained by adding the extrinsic information $L_{e,i}$ from all other decoders $j{\neq}i$. As shown in the figure, an appropriate interleaving is required in order to allow the summation of extrinsic information. This can be formalized as

$$L_{a,i} = \pi_i\left(\sum_{j\neq i}\widetilde{L}_{e,j}\right) = \pi_i\left(\sum_{j\neq i}\pi_i^{-1}\left(L_{e,j}\right)\right) \qquad (6)$$

Finally, the L-values of all a-posteriori outputs are summed up to obtain the L-value of the decoded bits $L(\hat{u})$. Note that for practical decoding, only those component decoders have to be considered in the decoding process which receive un-punctured channel values, Hence, there is always a finite number of decoders involved. The actual number of required component decoders depends on the receiver pattern.

IV. PERFORMANCE EVALUATION

*A. Simulation Environment*

In order to evaluate the performance of the presented turbo-fountain realizations we modeled a simplified wireless system and we performed extensive simulations. Usually, in state-of-the-art wireless systems like, e.g. GPRS or UMTS, data to be transmitted is segmented and mapped onto radio blocks. Data segments carried by these radio blocks are optionally protected with an error correcting code, e.g. convolutional code in GPRS. Usually a Cyclic Redundancy Check (CRC) sequence is inserted in order to perform error detection. Various strategies can be performed if residual bit errors are detected within received radio blocks. Usually erroneous radio blocks are declared as erased and are not forwarded to upper layers. Alternatively, the erroneous blocks can be used for further processing, or soft information, i.e. L-values about each bit within the radio block, is made available (We assume that header information is always available in a correct way. This can be achieved by protecting headers with lower code rate, like e.g in EGPRS. We do not consider header overhead in our performance evaluation).

Fig. 5. System diagram of the simulation setup.

In the following we introduce a simulation environment, which models the characteristic of segmentation and radio block protection in a simplified but still meaningful way in order to determine the performance of the turbo-fountain for asynchronous data access. Fig. 5 shows the block diagram of our simulation environment. The information sequence of length $k$ bit is encoded with the turbo-fountain encoder which outputs the infinite code sequence $c$. The segmentation unit truncates the continuous input bit-stream into segments $s_i$ of b bits length and outputs the segment sequence $s = (s_1, s_2, ...)$. A convolutional encoder with rate $R$ is used to encode each segment $s_i$. The encoded bits are BPSK modulated and mapped onto a radio block sequence $x = (x_1, x_2, ...)$, which is transmitted over the channel. At the channel output the received sequence $\hat{x} = (\hat{x}_1, \hat{x}_2, ...)$ containing L-values about each received bit is obtained which is passed to the channel decoder. The received radio blocks $\hat{x}_i$ are decoded with a Max-Log-Map decoder [15] [16] which outputs the segment sequence $\hat{s} = (\hat{s}_1, \hat{s}_2, ...)$. We consider two cases. In the first case $s_i$ contains L-values about each decoded bit. In the second case, the error detection mechanism is evaluated. If residual bit errors are detected, the received segment is declared as erased at the receiver. This is indicated with an erasure marker, i.e. $s_i = e$ (Note that the L-value of an erased symbol is given by $L(e) = 0$). The reassembly unit concatenates the received segments (including erasure segments) to a continuous sequence $y = (y_1, y_2, ...)$.

The crucial part of the simulation environment is the receiver control. The receiver control determines the receiver pattern $r$. As introduced in Section II-B, the receiver pattern decides which $y_i$ is punctured away, which represents whether the receiver listens to the channel or not. The punctured $\hat{c} = (\hat{c}_1, \hat{c}_2, ...)$ is passed to the fountain decoder which outputs $\hat{u} = (\hat{u}_1, ..., \hat{u}_k)$ as an estimate of $u$. The decoder indicates decoding success to the receiver control (We assume that appropriate error detection is available, e.g. by inserting CRC bits in u). Let $d$ denote the time index at which decoding is successful, i.e. enough symbols are received. Hence, the receiver control sets $r_i = 0 \; \forall i > d$. Note, in a practical system the puncturing unit would be placed before channel decoder.

Theoretically, any arbitrary realization of the receiver pattern could be selected. However, it is infeasible to consider all possible random receiver patterns within the simulation, since the receiver pattern is of infinite length. Furthermore, many receiver patterns which indeed spread the reception over a finite time period are impractical, though theoretically possible. Hence, we reduce the set of possible receiver patterns. Only receiver patterns which initiate a continuous reception of segments from the channel are selected. This describes a setup where a receiver randomly joins the data reception (asynchronous access) but does not interrupt the reception until it is able to decode the information message. This is the case within a typical wireless scenario without reception interrupts. Within a large number of simulation runs we tracked the minimum number of un-punctured symbols required to be received at the receiver in order to achieve decoding success. Let $\xi$ denote the mean value of the number of required symbols to be obtained from the channel at a specific $E_s/N_0$. Hence, we define $k/\xi$ as the average receiver throughput. In order to avoid useless decoding attempts after each symbol reception at the receiver, we initiate the decoding procedure the first time after reception of $k$ bits.

*B. Simulation Parameters*

Before we present the simulations results, we introduce briefly the system parameters. For all performed simulations we selected a radio block size of 1 = 320 bit. We investigate the system performance for two different radio protection modes, uncoded transmission, with $R$=1, and alternatively coded transmission with code rate $R$=0.5. In the later case, we applied a memory M = 4 recursive systematic convolutional code with generator polynomial $[37,21]_8$ in octal representation. The segment b is adjusted appropriately with the applied code rate R. For the component encoders of the TF-A encoder and the TF-B encoder, we selected memory M = 2 recursive systematic convolutional codes with generator matrix $[5,7]_8$. Since, broadcast solutions with fountain codes should allow transmission of long information messages, at least in the order of kilobytes up to several megabytes, we selected sliding window Max-Log-Map component decoders [15], [16], [17]. A sliding window decoder allows decoding of long code sequences with manageable memory requirements. Furthermore, recently efficient hardware implementations based on analog circuits have been presented [18], which allow decoding speeds up to several Gbit/s [19]. We present performance results for information block lengths k = 16000 bit and k = 50000 bit in the following, and perform l = 15 iterations at the receiver. We investigate the performance on the AWGN, the symbol-wise Rayleigh fading and the block-wise Rayleigh fading channel.

*C. Simulation Results*

Fig. 6 shows simulation results on the AWGN channel. The average receiver throughput $k/\xi$ is shown versus $E_s/N_0$, with $E_s$ denoting the energy per BPSK symbol and $N_0$ the noise power spectral density. As can be observed, the throughput is increasing with increasing $E_s/N_0$ for all compared schemes.

Fig. 6. Simulation results on the AWGN channel. Average receiver through-put $k/\xi$ vs. $E_s/N_0$.

First, we investigated the performance of an IEFC, which serves as an reference system in the following. Erroneously received radio blocks are declared as erased at the receiver, according to Section IV-A. Note, since IEFCs have not been found, we just assume that decoding of the information message would be successful, if k bits have been received un-erased and un-punctured at the receiver. This serves as an upper bound for all practical erasure based fountain codes. Without additional radio block protection, i.e. R = 1, sufficient throughput can only be achieved for $E_s/N_0 > 4dB$. However, for increasing $E_s/N_0$ the average throughput reaches $k/\xi = 1$. Applying radio block protection with rate $R = 0.5$, the system is able to support receivers with lower $E_s/N_0$ as well, since less radio blocks are declared as erased. However, the maximum achievable throughput is limited to $k/\xi = R$, since in an broadcast scenario link adaptation, i.e. swiching of coding schemes, cannot be performed. Unfortunately, an erasure based fountain code remains a huge gap compared to a fountain code operating at the capacity of the AWGN chanel.

In the contrast, the turbo-fountain TF-A in combination with R = 1 approaches the capacity over the entire investigated region, only with a small remaining gap. As can be observed, for the longer information sequence k = 50000 the performance is even increased compared to TF-A with k = 16000. For $E_s/N_0 > 7dB$ the IEFC outperforms the TFA. However, practical EFC codes are below the IEFC bound and furthermore, the point of operation in an wireless systems is expected to be located for many receivers somewhere in the lower $E_s/N_0$ region. Interestingly, the performance of TF-B is noticeably weaker, compared to TF-A, though the encoder and decoder complexity is much higher, due to multiple component codes. However, it still shows huge performance gains compared to IEFC for low $E_s/N_0$. Radio block protection ($R = 0.5$) in combination with turbo-fountain does not show any advantages over the entire $E_s/N_0$ region.

Fig. 7. Simulation results on symbol-wise Rayleigh fading channel. Average receiver throughput $k/\xi$ vs. $E_s/N_0$.

Fig. 7 and Fig. 8 show the simulation results for the symbol-wise Rayleigh fading and the block fading channel, respectively. Basically, the same tendencies as explained for the AWGN channel can be observed. However, for symbol-wise fading, which is a fairly good channel model for fast moving wireless receivers, any IEFC with R = 1 cannot provide any throughput, since with high probability in every radio block bits are received erroneously. Hence, EFCs are only practical with radio block protection. Now, TF-A without radio block protection outperforms all presented schemes significantly in the entire investigated $E_s/N_0$ region.

On the block fading channel, the performance of the turbo-fountain (TF-A and TF-B) is mostly equivalent to the performance on the symbol-wise fading channel. This comes from the fact that for both channel types have the ergodic capacity is equivalent. However, since with block fading the fading gain varies only from block to block, the IEFC performance is different, but provides a huge gap to the turbo-fountain.

Fig. 8. Simulation results on the block-wise Rayleigh fading channel. Average receiver throughput $k/\xi$ vs. signal-to-noise ratio $E_s/N_0$.

### D. Discussion

As shown in the previous subsection, the turbo-fountain TFA shows impressive results, but still remains a gap to capacity. However, this encourages for future work to close this gap. Interestingly, the performance of TF-B is worse compared to TF-A. The reason for this is that the encoder structure outputs only at the beginning systematic information. This indeed reduces the performance, since turbo codes require systematic bits in order to achieve good performance, although the collection of identical code bits is avoided with this structure. On the other hand, the turbo-fountain TF-A cannot avoid the collection of identical code bits multiple times at the receiver, due to its interleaved repetition structure. However, the results show that a fountain code can already be very well approximate with an interleaved repetition structure, based on an rate 1/3 turbo code, since bits collected multiple times at the receiver are not useless, but increase the likelihood of this bits, which is not the case with erasure based decoding.

### V. CONCLUSIONS AND FUTURE WORK

In this work we investigated fountain coding as a solution for the problem of reliable wireless broadcast with asynchronous access. We extended the traditional problem formalization of ideal fountain codes on erasure channel to arbitrary channel types. We introduced the *turbo-fountain,* based on turbo codes, as a possible approximation of a fountain code. We presented two different structures of the turbo-fountain and compared the performance of the turbo-fountain to an ideal erasure based fountain code with appropriate erasure declaration on the AWGN, the symbol-wise Rayleigh fading and the block-fading channel. We considered decoding based on soft-information from the channel for the turbo-fountain. Huge performance gains of the turbo-fountain have been shown compared to ideal erasure based codes over the $E_s/N_0$ region of interest. Moreover, the turbo-fountain was shown to operate close to capacity, only with a small remaining gap. We showed that additional radio block protection is not required if the turbo-fountain is applied. Since there is a remaining gap to the capacity, future work will consider optimization of the turbo-fountain towards capacity. Furthermore, we will extend the system model, in order to consider reception pauses, and will consider more arbitrary receiver pattern.

### REFERENCES

[1] J. Nonnenmacher and E. Biersack, "Reliable multicast: Where to use forward error correction," *Proc. IFIP 5th Int. Workshop Protocols High- Speed Networks, Sophia Antipolis, France,* pp. 134-148, Oct. 1996.

[2] L. Rizzo and L. Vicisano, "A reiliable multicast data distribution protocol based on software FEC techniques," *Proc. HPCS*, 1997.

[3] J. Byers, M. Luby, and M. Mitzenmacher, "A digital fountain approach to asynchronous reliable multicast," *IEEE Journal on Selected Areas in Communications,* vol. 20, pp. 1528-1540, Oct. 2002.

[4] M. Luby, "LT codes," in *Proc. 43rd Annual IEEE Symposium on Foundations of Computer Science,* 2002.

[5] A. Shokrollahi, "Raptor codes," Digital Fountain, Tech. Rep. DR2003- 06-001, Jun. 2003.

[6] R. Palanki and J. Yedidia, "Rateless codes on noisy channels," *Proc. International Symposium on Information Theory (ISIT) 2004, Chicago,*

*IL, USA,* p. 37, June 2004.

[7] R. Palanki, "Iterative decoding for wireless networks," *PHD Thesis submitted to California Institute of Technology,* May 2004.

[8] M. Mitzenmacher, "Digital fountains: A survey and look forward," *Proc. of the IEEE Information Theory Workshop 2004, San Antonio, TX, USA,* pp. 271-276, Oct. 2004.

[9] P. Maymounkov and D. Mazieres, "Rateless codes and big downloads," *Proc. of the 2nd International Workshop on Peer-to-Peer Systems,* Feb. 2003.

[10] J. Hagenauer, E. Offer, and L. Papke, "Iterative decoding of binary block and convolutional codes," *IEEE Transactions on Information Theory,* vol. 42, pp. 429-445, Mar. 1996.

[11] C. Berrou, A. Glavieux, and P. Thitimajshima, "Near Shannon limit error-correcting coding and decoding: Turbo codes," *Proc. IEEE International Conference on Communications, Geneva, Switzerland,* May 1993.

[12] J. Hagenauer, "The turbo principle in mobile comminications," *Proc. International Symposium on Nonlinear Theory and its Applications, Xi'an, China,* Oct. 2002.

[13] D. Divsalar and F. Pollara, "Multiple turbo codes for deep-space communications," *TDA Progress Report 42-121,* pp. 66-77, May 1995.

[14] C. He, D. Costello, A. Huebner, and K. Zigangirov, "Joint interleaver design for low complexity multiple turbo codes," *ITW2003, Hong Kong,*

July 2003.

[15] L. Bahl, J. Cocke, F. Jelinek, and J. Raviv, "Optimal decoding of linear codes for minimizing symbol error rate," *IEEE Transactions on Information Theory,* vol. IT-20, pp. 284-287, Mar. 1974.

[16] P. Robertson, E. Villebrun, and P. Hoeher, "A comparison of optimal and sub-optimal MAP decoding algorithms operating in the log domain," *IEEE Transactions,* pp. 1009-1013, Feb. 1995.

[17] S. Benedetto, D. Divsalar, G. Montorsi, and F. Pollara, "Soft-output decoding algorithms in iterative decoding of turbo-codes," *JPL TDA Progress Report,* pp. 42-124, Feb. 1996.

[18] M. Moerz, "Analog sliding window decoder core for mixed signal turbo decoder," *Proc. of the 5th International ITG Conference on Source and Channel Coding (SCC'04), Erlangen, Germany,* Jan. 2004.

[19] —, "Analog turbo-decoding in VLSI," *PHD Thesis, Munich University of Technology, to be submitted*, Feb. 2005.

**Claims**

1. Apparatus for encoding an information message consisting of

   - at least one concatenated encoder, which consists of at least two component encoders and of at least one interleaver, such as a parallel concatenated Turbo encoder, and
   - at least one interleaver.

2. Apparatus according to claim 1, whereby the interleaver(s) follows the concatenated encoder(s) to spread the generated code symbols.

3. Apparatus according to claim 1, whereby the concatenated encoder(s) follows the interleaver(s).

4. Method according to any one of the preceding claims, whereby the encoded and interleaved data are transmitted in packets.

5. Method according to any one of the preceding claims, whereby multiple receivers join the reception of encoded data asynchronously

6. Method according to any one of the preceding claims, whereby the interleaver(s) before or behind the concatenated encoder(s) are different from each other.

**7.** Method according to any one of the preceding claims, whereby the encoded and interleaved data are received and are correspondingly deinterleaved and decoded.

**8.** Method according to claim 7, whereby the reliability information generated by one component decoder is taken into account in decoding by another component decoder.

**9.** Method according to claim 8, whereby the decoding is done iteratively.

**10.** Method according to any one of the preceding claims, whereby decoding is performed on a subset of received code symbols.

**11.** Method according to any one of the preceding claims, whereby the decoding operation is only performed if the number of available code symbols at the decoder exceeds a threshold.

**12.** Method according to claim 11, whereby the threshold depends on the data word length and/or the channel capacity and/or on preceding decoding failure or success.

**13.** Method according to any one of the preceding claims **characterized in that** it is applied in broadcasting services, especially multimedia broadcast and multicast services.

**European Patent Office**

# EUROPEAN SEARCH REPORT

Application Number

EP 04 02 7770

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | BENEDETTO S ET AL: "ANALYSIS, DESIGN, AND ITERATIVE DECODING OF DOUBLE SERIALLY CONCATENATED CODES WITH INTERLEAVERS" IEEE JOURNAL ON SELECTED AREAS IN COMMUNICATIONS, IEEE INC. NEW YORK, US, vol. 16, no. 2, February 1998 (1998-02), pages 231-244, XP000741777 ISSN: 0733-8716 * figures 1,9 * | 1-13 | H03M13/29 |
| D,A | BERROU C ET AL: "NEAR SHANNON LIMIT ERROR - CORRECTING CODING AND DECODING: TURBO-CODES (1)" PROCEEDINGS OF THE INTERNATIONAL CONFERENCE ON COMMUNICATIONS (ICC). GENEVA, MAY 23 - 26, 1993, NEW YORK, IEEE, US, vol. VOL. 2, 23 May 1993 (1993-05-23), pages 1064-1070, XP000371240 ISBN: 0-7803-0950-2 * figure 2 * | 1-13 | |
| A | AIT SAB O: "FEC Contribution in Submarine Transmission Systems" SUBOPTIC. INTERNATIONAL CONVENTION. THE INTERNATIONAL CONVENTION ON UNDERSEA COMMUNICATIONS, XX, XX, May 2001 (2001-05), pages 496-499, XP001151605 * figures 2,4 * | 1-13 | TECHNICAL FIELDS SEARCHED (Int.Cl.7) H03M |

-----

-----

-----

-/--

The present search report has been drawn up for all claims

| Place of search | Date of completion of the search | Examiner |
|---|---|---|
| The Hague | 19 January 2005 | Van Staveren, M |

**EP 1 659 695 A1**

European Patent
Office

**EUROPEAN SEARCH REPORT**

Application Number

EP 04 02 7770

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | J. NONNENMACHER, E.W. BIERSACK: "Reliable Multicast: Where to use FEC" [Online] October 1996 (1996-10), pages 1-15, XP002314194 Retrieved from the Internet: URL:http://www.eurecom.fr/~btroup/BPublished/bib.html> [retrieved on 2005-01-19] * the whole document * ----- | 1-13 | |
| D,A | RIZZO L ET AL: "A reliable multicast data distribution protocol based on software FEC techniques" IEEE WORKSHOP ON HIGH-PERFORMANCE COMMUNICATION SYSTEMS. PROCEEDINGS OF WORKSHOP ON THE ARCHITECTURE AND IMPLEMENTATION OF HIGH PERFORMANCE COMMUNICATIONS SUBSYSTEMS, XX, XX, 23 June 1997 (1997-06-23), pages 115-124, XP002181851 * the whole document * ----- | 1-13 | |
| D,A | BYERS J W ET AL: "A DIGITAL FOUNTAIN APPROACH TO ASYNCHRONOUS RELIABLE MULTICAST" IEEE JOURNAL ON SELECTED AREAS IN COMMUNICATIONS, IEEE INC. NEW YORK, US, vol. 20, no. 8, October 2002 (2002-10), pages 1528-1540, XP001168306 ISSN: 0733-8716 * the whole document * ----- -/-- | 1-13 | TECHNICAL FIELDS SEARCHED (Int.Cl.7) |

The present search report has been drawn up for all claims

| Place of search | Date of completion of the search | Examiner |
|---|---|---|
| The Hague | 19 January 2005 | Van Staveren, M |

EPO FORM 1503 03.82 (P04C01)

15

**European Patent Office**

**EUROPEAN SEARCH REPORT**

Application Number

EP 04 02 7770

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | LUBY M ED - INSTITUTE OF ELECTRICAL AND ELECTRONICS ENGINEERS: "LT codes" 43RD. ANNUAL SYMPOSIUM ON FOUNDATIONS OF COMPUTER SCIENCE.(FOCS 2002). VANCOUVER, BC, CANADA, NOV. 16 - 19, 2002, ANNUAL SYMPOSIUM ON FOUNDATIONS OF COMPUTER SCIENCE, LOS ALAMITOS, CA : IEEE COMP. SOC, US, 16 November 2002 (2002-11-16), pages 271-280, XP010628282 ISBN: 0-7695-1822-2 * the whole document * ----- | 1-13 | |
| D,A | PALANKI R ET AL: "Rateless codes on noisy channels" INFORMATION THEORY, 2004. ISIT 2004. PROCEEDINGS. INTERNATIONAL SYMPOSIUM ON CHICAGO, ILLINOIS, USA JUNE 27-JULY 2, 2004, PISCATAWAY, NJ, USA,IEEE, 27 June 2004 (2004-06-27), pages 38-38, XP010749749 ISBN: 0-7803-8280-3 * the whole document * ----- | 1 | |
| D,A | R. PALANKI: "Iterative Decoding for Wireless Networks"[Online] May 2004 (2004-05), pages 1-100, XP002314195 Retrieved from the Internet: URL:etd.caltech.edu/etd/available/ etd-05212004-153855/unrestricted/thesis.pd f> [retrieved on 2005-01-19] * the whole document * ----- -/-- | 1-13 | TECHNICAL FIELDS SEARCHED (Int.Cl.7) |

The present search report has been drawn up for all claims

| Place of search | Date of completion of the search | Examiner |
|---|---|---|
| The Hague | 19 January 2005 | Van Staveren, M |

EPO FORM 1503 03.82 (P04C01)

**European Patent Office**

**EUROPEAN SEARCH REPORT**

Application Number

EP 04 02 7770

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | M. MITZENMACHER: "Digital Fountains; A Survey and Look Forward" PROC. OF THE IEEE INFORMATION THEORY WORKSHOP 2004, [Online] October 2004 (2004-10), pages 271-276, XP002314196 Retrieved from the Internet: URL:www.eecs.harvard.edu/~michaelm/postscripts/itw2004.pdf> [retrieved on 2005-01-19] * the whole document * ----- | 1-13 | |
| D,A | P. MAYMOUNKOV, D. MAZIÈRES: "Rateless Codes and Big Downloads"[Online] February 2003 (2003-02), pages 1-6, XP002314197 Retrieved from the Internet: URL:http://www.scs.cs.nyu.edu/~petar/> [retrieved on 2005-01-19] * the whole document * ----- | 1-13 | TECHNICAL FIELDS SEARCHED (Int.Cl.7) |
| D,A | HAGENAUER J ET AL: "ITERATIVE DECODING OF BINARY BLOCK AND CONVOLUTIONAL CODES" IEEE TRANSACTIONS ON INFORMATION THEORY, IEEE INC. NEW YORK, US, vol. 42, no. 2, March 1996 (1996-03), pages 429-445, XP000850507 ISSN: 0018-9448 * the whole document * ----- | 1-13 | |
| D,A | BAUCH G ET AL: "ITERATIVE EQUALIZATION AND DECODING IN MOBILE COMMUNICATIONS SYSTEMS" PROCEEDINGS OF EUROPEAN PERSONAL AND MOBILE COMMUNICATIONS CONFERENCE, XX, XX, 30 September 1997 (1997-09-30), pages 307-312, XP002060630 * the whole document * ----- -/-- | 1-13 | |

The present search report has been drawn up for all claims

| Place of search | Date of completion of the search | Examiner |
|---|---|---|
| The Hague | 19 January 2005 | Van Staveren, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

## EUROPEAN SEARCH REPORT

Application Number

EP 04 02 7770

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | DIVSALAR D ET AL: "Multiple Turbo Codes for Deep Space Communications" TDA PROGRESS REPORT, XX, XX, no. REP 42-121, 15 May 1995 (1995-05-15), pages 66-77, XP002251816 * the whole document * | 1-13 | |
| D,A | C. HE, D. COSTELLO, A. HUEBNER, K.SH. ZIGANGIROV: "Joint Interleaver Design for Low Complexity Multiple Turbo Codes" ITW2003, [Online] 6 July 2003 (2003-07-06), - 10 July 2003 (2003-07-10) pages 1-2, XP002314198 HONG KONG Retrieved from the Internet: URL:tait.e-technik.uni-ulm.de/~huebner/ publications/itw.huebner.2003.pdf> [retrieved on 2005-01-19] * the whole document * | 1-13 | |
| D,A | BAHL L R ET AL: "OPTIMAL DECODING OF LINEAR CODES FOR MINIMIZING SYMBOL ERROR RATE" IEEE TRANSACTIONS ON INFORMATION THEORY, IEEE INC. NEW YORK, US, vol. IT-20, no. 2, March 1974 (1974-03), pages 284-287, XP000760833 ISSN: 0018-9448 * the whole document * | 1-13 | TECHNICAL FIELDS SEARCHED (Int.Cl.7) |

-/--

The present search report has been drawn up for all claims

| Place of search | Date of completion of the search | Examiner |
|---|---|---|
| The Hague | 19 January 2005 | Van Staveren, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

## EUROPEAN SEARCH REPORT

Application Number

EP 04 02 7770

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | ROBERTSON P ET AL: "A COMPARISON OF OPTIMAL AND SUB-OPTIMAL MAP DECODING ALGORITHMS OPERATING IN THE LOG DOMAIN" COMMUNICATIONS - GATEWAY TO GLOBALIZATION. PROCEEDINGS OF THE CONFERENCE ON COMMUNICATIONS. SEATTLE, JUNE 18 - 22, 1995, PROCEEDINGS OF THE CONFERENCE ON COMMUNICATIONS (ICC), NEW YORK, IEEE, US, vol. VOL. 2, 18 June 1995 (1995-06-18), pages 1009-1013, XP000533149 ISBN: 0-7803-2487-0 * the whole document * | 1-13 | |
| D,A | BENEDETTO S ET AL: "SOFT-OUTPUT DECODING ALGORITHMS IN ITERATIVE DECODING OF TURBO CODES" TDA PROGRESS REPORT, XX, XX, no. 42-124, 15 February 1996 (1996-02-15), pages 63-87, XP002155298 * the whole document * | 1-13 | |

TECHNICAL FIELDS SEARCHED (Int.Cl.7)

The present search report has been drawn up for all claims

| Place of search | Date of completion of the search | Examiner |
|---|---|---|
| The Hague | 19 January 2005 | Van Staveren, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)